# EUROPEAN PATENT APPLICATION

(11) **EP 4 375 510 A1**
(43) Date of publication of application: **29.05.2024**
(21) Application number: 22845299.1
(22) Date of filing: 19.07.2022
(51) Int. Cl.: F04C 11/00, F04C 2/10

(54) **FLUID DRIVE DEVICE**

(30) Priority: 19.07.2021 CN 202110814680
(71) Applicant: Hangzhou Ao Ke Mei Rui Technology Co., Ltd., Hangzhou, Zhejiang 310018 (CN)
(72) Inventor: HU, Meiyan, Hangzhou, Zhejiang 310018 (CN)
(74) Representative: Studio Torta S.p.A.
(86) International application number: PCT/CN2022/106407
(87) International publication number: WO 2023/001134

(57) **Abstract**

A fluid drive device, comprising a first rotor assembly (1), a second rotor assembly (3), a stator assembly (2) and a circuit board assembly (4), wherein the second rotor assembly (3) is transmissionally connected to the first rotor assembly (1), and the stator assembly (2) is electrically connected to the circuit board assembly (4). The fluid drive device is provided with a first cavity (80) and a second cavity (90); the first rotor assembly (1) is located in the first cavity (80), and the second rotor assembly (3), the stator assembly (2) and the circuit board assembly (4) are located in the second cavity (90); the first cavity (80) may have a working medium in circulation, and the second cavity (90) may accommodate the working medium; and when the second cavity (90) accommodates the working medium, at least part of the circuit board assembly (4) may make contact with the working medium located in the second cavity (90). The working medium of the fluid drive device may dissipate the heat from a circuit board, which is beneficial to improving service life.

## Description

This application claims priority to Chinese Patent Application No. 202110814680.0, titled "FLUID DRIVE DEVICE", filed with the China National Intellectual Property Administration on July 19, 2021, the entire disclosure of which is incorporated herein by reference in its entirety.

### FIELD

The present application relates to the technical field of vehicles, and in particular to a component of a lubrication system and/or a cooling system of a vehicle.

### BACKGROUND

A fluid drive device is mainly for providing a power source for a lubrication system and/or a cooling system of a vehicle. The fluid drive device includes a circuit board assembly which will generate heat during operation. If the heat accumulates to a certain extent and cannot be dissipated in time, the performance of the circuit board assembly will be degraded, thus reducing the service life of the fluid drive device.

### SUMMARY

An object of the present application is to provide a fluid drive device, which facilitates heat dissipation of a circuit board assembly, thus improving the service life of the fluid drive device.

In order to achieve the above objects, the following technical solution is provided according to an embodiment of the present application.

A fluid drive device includes a first rotor assembly, a second rotor assembly, a stator assembly and a circuit board assembly, where the second rotor assembly is connected torque-transmissively to the first rotor assembly, and the stator assembly is electrically connected to the circuit board assembly. The fluid drive device is provided with a first chamber and a second chamber, where the first rotor assembly is located in the first chamber, and the stator assembly and the circuit board assembly are located in the second chamber. The first chamber is configured for allowing a working medium to flow therethrough, and the second chamber is configured for accommodating the working medium. When the second chamber accommodates the working medium, at least part of the circuit board assembly is in contact with the working medium located in the second chamber.

In the technical solution of the present application, the fluid drive device is provided with a first chamber and a second chamber, where the first rotor assembly is located in the first chamber, and the stator assembly and the circuit board assembly are located in the second chamber. The first chamber is configured for allowing the working medium to flow therethrough, and the second chamber is configured for accommodating the working medium. When the second chamber accommodates the working medium, at least part of the circuit board assembly is in contact with the working medium located in the second chamber. In this way, the working medium in the second chamber can exchange heat with the heat generated by the circuit board assembly, which facilitates the heat dissipation of the circuit board assembly and is further beneficial to improving the service life of the fluid drive device.

### BRIEF DESCRIPTION OF THE DRAWINGS

FIG. 1 is a schematic cross-sectional view of a first embodiment of a fluid drive device according to the present application;
FIG. 2 is a schematic front view of a partial structure of the fluid drive device in FIG. 1 without an upper cover;
FIG. 3 is a schematic perspective view of a circuit board assembly in FIG. 1, viewed from one perspective;
FIG. 4 is a schematic perspective view of the circuit board assembly in FIG. 1, viewed from another perspective; and
FIG. 5 is a schematic cross-sectional view of a second embodiment of the fluid drive device according to the present application.

### DETAILED DESCRIPTION OF THE EMBODIMENTS

The present application is further illustrated hereinafter in conjunction with drawings and specific embodiments.

The specific embodiments of the present application are described in detail hereinafter in conjunction with the drawings. First of all, it should be noted that the location terms, such as upper, lower, left, right, front, rear, inside, outside, top and bottom, mentioned or possibly mentioned in this specification are relative concepts defined based on those constructs shown in the corresponding drawings, and therefore may vary with locations or states of use. Therefore, these and other location terms should not be construed as restrictive terms.

A fluid drive device in the following embodiments can provide power for flow of the working medium of the vehicle lubrication system and/or vehicle cooling system, and in particular can provide power for flow of the working medium of the lubrication system and/or cooling system in a vehicle transmission system.

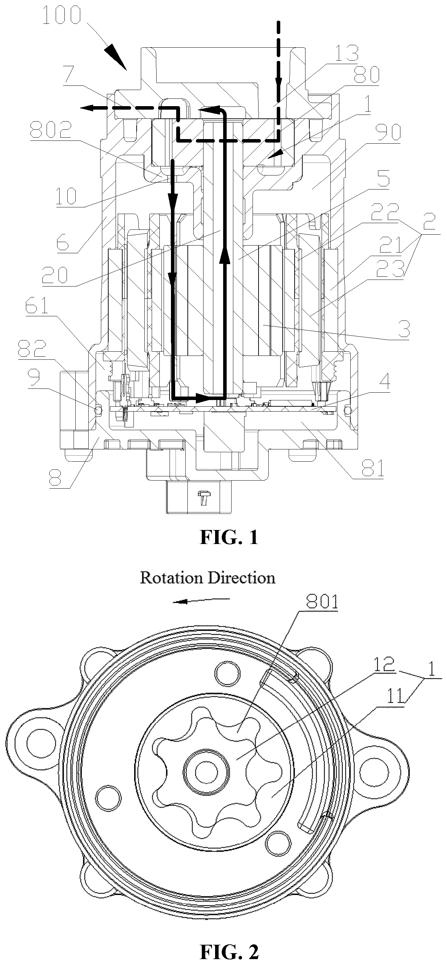

Referring to FIG. 1 and FIG. 2, a fluid drive device 100 includes a first rotor assembly 1, a stator assembly 2, a second rotor assembly 3, and a circuit board assembly 4. The circuit board assembly 4 may supply electrical power to coils in the stator assembly 2, and also control an operation of the first rotor assembly 1 in real time based on the operation environment. The fluid drive device 100 is provided with a first chamber 80 and a second chamber 90. The first rotor assembly 1 is arranged in the first chamber 80, and the stator assembly 2, the second rotor assembly 3 and the circuit board assembly 4 are arranged in the second chamber 90. The stator assembly 2 includes a stator core 21, an insulating frame 22 and a winding 23. The insulating frame 22 covers at least part of a surface of the stator core 21, and the winding 23 is wound around the insulating frame 22. During the operation of the fluid drive device 100, the circuit board assembly 4 controls the stator assembly 2 to generate a changing excitation magnetic field by controlling the current passing through the winding 23 of the stator assembly 2 to vary according to a predetermined rule, and the second rotor assembly 3 rotates under an action of the excitation magnetic field. The second rotor assembly 3 is connected torque-transmissively to the first rotor assembly and may directly or indirectly drive the first rotor assembly 1 to rotate. When the first rotor assembly 1 rotates, a volume of a hydraulic chamber 801 between the first rotor assembly 1 varies, so that the working medium, which is cooling oil in this embodiment, is pressed out to an outflow passage to generate the power for flow. Referring to FIG. 1, in this embodiment, the stator core 21 is located between the first rotor assembly 1 and the circuit board assembly 4 in a height direction of the fluid drive device 100, and the stator core 21 is closer to the first rotor assembly 1 than the circuit board assembly 4. Also, in other embodiments, at least part of the circuit board assembly 4 may be located between the first rotor assembly 1 and the stator core 21 in the height direction of the fluid drive device 100, and the circuit board assembly 4 is closer to the first rotor assembly 1 than the stator core 21.

In particular, referring to FIG. 1 and FIG. 2, the first rotor assembly 1 includes a first rotor 11 and a second rotor 12. The first rotor 11 includes multiple internal teeth, and the second rotor 12 includes multiple external teeth. The hydraulic chamber 801 is formed between the internal teeth of the first rotor 11 and the external teeth of the second rotor 12. In this embodiment, the hydraulic chamber 801 is also a part of the first chamber 80. In this embodiment, the first rotor 11 is sleeved outside an outer periphery of the second rotor 12. Referring to FIG. 1 again, the fluid drive device 100 further includes an inflow passage 13 and an outflow passage (not shown). The working medium can enter the hydraulic chamber 801 through the inflow passage 13 and leave the hydraulic chamber 801 through the outflow passage (not shown). Since there is a certain eccentricity between the first rotor 11 and the second rotor 12, some of the external teeth of the second rotor 12 are in engagement with some of the internal teeth of the first rotor 11 when the second rotor 12 rotates, thus driving the first rotor 11 to rotate. During one revolution of the first rotor 11 and the second rotor 12, an internal volume of the hydraulic chamber 801 varies. In particular, when the first rotor 11 of the first rotor assembly 1 rotates to a certain angle from an initial position, the volume in the hydraulic chamber 801 gradually increases to form a partial vacuum, and the working medium is sucked into the hydraulic chamber 801 from the inflow passage 13. When the first rotor 11 and the second rotor 12 further rotate, the volume of the hydraulic chamber 801 originally filled with the working medium gradually decreases, and the working medium is squeezed, so that the working medium entering the hydraulic chamber 801 is pressed out to the outflow passage (not shown) to generate the power for flow. In this embodiment, the fluid drive device 100 further includes a shaft 5 which can drive part of the first rotor assembly 1 to rotate. In particular, in this embodiment, the shaft 5 can drive the first rotor 11 to rotate. In this embodiment, one side of the shaft 5 is connected with the first rotor 11, and the other side of the shaft 5 is connected with the second rotor assembly 3. The second rotor assembly 3 drives the second rotor 12 to rotate through the shaft 5, thus realizing the rotation of the first rotor assembly 1.

Referring to FIG. 1, the fluid drive device 100 further includes a motor housing 6, an upper cover 7 and a bottom cover 8. At least part of the motor housing 6 is located between the upper cover 7 and the bottom cover 8 in the height direction of the fluid drive device 100. One side of the motor housing 6 is relatively fixedly connected with the upper cover 7, and the other side of the motor housing 6 is relatively fixedly connected with the bottom cover 8. The motor housing 6 is provided with a first accommodating chamber 61. The stator assembly 2 is located in the first accommodating chamber 61, and the first accommodating chamber 61 is a part of the second chamber 90. The bottom cover 8 has a second accommodating chamber 81. The circuit board assembly 4 is located in the second accommodating chamber 81, and the second accommodating chamber 81 is a part of the second chamber 90. Also, in other embodiments, the bottom cover 8 may not be provided with the second accommodating chamber 81, the circuit board assembly 4 may be located in the first accommodating chamber 61, and the first accommodating chamber 61 may constitute the entire second chamber 90. Referring to FIG. 1, a joint between opposing peripheral side walls of the bottom cover 8 and the first accommodating chamber 61 is sealed, which is beneficial to preventing the working medium in the second chamber 90 from leaking to the outside from the joint between the opposing peripheral side walls of the bottom cover 8 and the first accommodating chamber 61. Moreover, the fluid drive device is more compact in the axial direction, which is beneficial to the miniaturization design of the fluid drive device. In particular, referring to FIG. 1, in this embodiment, the fluid drive device 100 further includes a first sealing ring 9. The bottom cover 8 is provided with a groove 82 which is recessed from the outer peripheral surface of the bottom cover 8. At least part of the first sealing ring 9 is located in the groove 82. One side of the first sealing ring 9 abuts against the corresponding bottom surface of the groove 82, and the other side of the first sealing ring 9 abuts against the corresponding peripheral side wall of the first accommodating chamber 61. When the second chamber 90 accommodates the working medium, such arrangement is beneficial to reducing the leakage of the working medium in the second chamber 90, thereby improving the oil supply efficiency of the fluid drive device.

Referring to FIG. 1, FIG. 1 is a schematic structural view of a first embodiment of the fluid drive device according to the present application, and the structure of the first embodiment of the fluid drive device will be described in detail below.

Referring to FIG. 1, the second chamber 90 can accommodate the working medium. When the second chamber 90 accommodates the working medium, at least part of the circuit board assembly 4 is in contact with the working medium located in the second chamber 90. In this way, the working medium in the second chamber 90 can exchange heat with the heat generated by the circuit board assembly 4, which facilitates the heat dissipation of the circuit board assembly 4 and is further beneficial to improving the service life of the fluid drive device 100.

In particular, referring to FIG. 1, in this embodiment, the first chamber 80 is in communication with the second chamber 90. In particular, referring to FIG. 1, the wall surface corresponding to the first chamber 80 includes a bottom wall 802 which supports the first rotor assembly 1. The fluid drive device 100 further includes a first passage 10 which extends through an upper surface and a lower surface of the bottom wall 802. The first passage 10 communicates the first chamber 80 with the second chamber 90. At least part of the working medium in the first chamber 80 can flow into the second chamber 90 through the first passage 10 and contact with at least part of the circuit board assembly 4 located in the second chamber 90, so that the working medium in the second chamber 90 can exchange heat with the heat generated by the circuit board assembly 4, which facilitates the heat dissipation of the circuit board assembly 4 and is further beneficial to improving the service life of the fluid drive device 100. Further, in this embodiment, at least part of the stator assembly 2 may also be in contact with the working medium in the second chamber 90, so that the heat generated by the stator assembly 2 can also exchange heat with the working medium in the second chamber 90, which facilitates the heat dissipation of the stator assembly 2 and is further beneficial to prolonging the service life of the fluid drive device 100. Referring to FIG. 1, in this embodiment, the fluid drive device 100 further includes a second passage 20 which is arranged to extend through an upper end face and a lower end face of the shaft 5. The working medium in the second chamber 90 can leave the second chamber 90 through the second passage 20. An outlet of the second passage 20 is closer to the inflow passage 13 than an inlet of the first passage 10, and the pressure of the working medium at the inlet of the first passage 10 is greater than the pressure at the outlet of the second passage 20. In this way, a pressure difference of the working medium is formed between the inlet of the first passage 10 and the outlet of the second passage 20. According to a principle that the working medium flows from a place with high pressure to a place with low pressure, the working medium in the second chamber 90 can flow towards the outlet of the second passage 20, that is, the working medium in the second chamber 90 can leave the second chamber 90 through the second passage 20. Since the stator assembly 2 and the circuit board assembly 4 are arranged in the second chamber 90, the flowing working medium can take away at least part of the heat of the stator assembly 2 and the circuit board assembly 4, which is further beneficial to improving the heat dissipation efficiency of the stator assembly 2 and the circuit board assembly 4. Referring to FIG. 1, in this embodiment, the second passage 20 is in communication with the outflow passage of the fluid drive device 100. That is to say, the working medium in the second chamber 90 is directly inputted to the outside of the fluid drive device through the outflow passage, which facilitates the heat dissipation of the circuit board assembly and/or the stator assembly in the second chamber 90, and makes the structure of the fluid drive device more compact, which is beneficial to the miniaturization design of the fluid drive device.

Referring to FIG. 1, FIG. 1 shows flow directions of the working medium. In particular, the working medium has two flow directions. In order to better illustrate the flow directions of the working medium, a thick dashed line in FIG. 1 is a first flow direction, and a thick solid line is a second flow direction. In the first flow direction, the working medium flows from the inflow passage 13 into the volume chamber between the first rotor assembly 1, and then flows out of the volume chamber from the outflow passage. In the second flow direction, a part of the working medium that enters the volume chamber between the first rotor assembly 1 flows from the first passage 10 to the second chamber 90, and then the working medium in the second chamber 90 flows out from the second passage 20 to the outflow passage. In this embodiment, an inflow direction of the working medium is a vertical direction, and an outflow direction of the working medium is a horizontal direction, in which the "vertical direction" and the "horizontal direction" are directions defined as the fluid drive device 100 is arranged in a state as shown in FIG. 1. Also, in other embodiments, the inflow direction and the outflow direction of the working medium may be arranged in parallel with each other.

Referring to FIG. 1, in this embodiment, the first chamber 80 is in communication with the second chamber 90, so that there is working medium accommodated in the second chamber 90, and at least part of the circuit board assembly 4 is in contact with the working medium located in the second chamber 90. Also, in other embodiments, the working medium can be accommodated in the second chamber 90 by other means. For example, the corresponding inflow passage and outflow passage may be formed in the motor housing, so that the working medium can directly enter the second chamber 90 from the inflow passage on the motor housing, and directly leave the second chamber 90 through the outflow passage on the motor housing. In such case, the second chamber 90 and the first chamber 80 may or may not communicate with each other. In this way, in a case that the second chamber 90 is not in communication with the first chamber 80, it is still possible to dissipate heat for the circuit board assembly 4 and/or the stator assembly 2 in the second chamber 90, which is beneficial to improving the output efficiency of the fluid drive device, for example, the oil pumping efficiency.

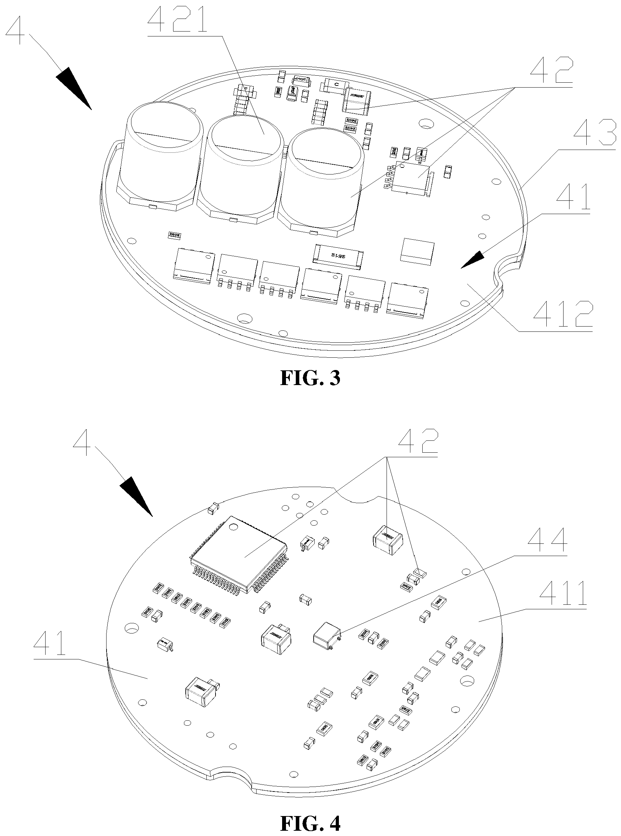

Referring to FIG. 3 and FIG. 4, the circuit board assembly 4 includes a base board 41 and electronic components 42 which are fixedly connected with the base board 41. At least part of the external surface of the electronic components 42 is covered with a protective film, which is beneficial to preventing the electronic components 42 from being corroded by the working medium. The electronic components 42 herein include capacitors, resistors, inductors, processors and other electronic components.

Referring to FIG. 4, the fluid drive device 100 further includes a temperature sensing unit 44 electrically connected with the circuit board assembly 4 and electrically connected with the base board 41. The temperature sensing unit 44 is in contact with the working medium in the second chamber 90 to detect the temperature of the working medium in the second chamber 90. In this way, the operation state of the fluid drive device 100 can be adjusted by the control system based on the temperature of the working medium. In this embodiment, the temperature sensing unit 44 may be a thermistor, a temperature sensor or other temperature detecting element.

Referring to FIG. 3 and FIG. 4, in this embodiment, the base board 41 includes a front surface 411 and a back surface 412 which are arranged opposite to each other. In the height direction of the fluid drive device 100, the front surface 411 is closer to the first rotor assembly 1 than the back surface 412. The temperature sensing unit 44 is supported on the front surface 411. The electronic components 42 include heat-generating electronic components such as field-effect transistors (Mosfet) and capacitors 421. The heat-generating electronic components are arranged on the back surface 412, which is beneficial to preventing the heat of the heat-generating electronic components from interfering with the detection accuracy of the temperature sensing unit 44. Also, in other embodiments, the temperature sensing unit 44 may be supported on the back surface 412, and correspondingly the heat-generating electronic components be supported on the front surface 411.

Referring to FIG. 3, the circuit board assembly 4 further includes an adhesive portion 43 supported on and adhered to the base board 41. In particular, in this embodiment, the adhesive portion 43 is adhered to the back surface 412 of the base board 41, and an outer contour of the adhesive portion 43 is in a closed shape. In this embodiment, all of the electronic components arranged on the back surface 412 of the base board 41 are located in an area surrounded by the adhesive portion 43, and the area surrounded by the adhesive portion 43 is filled with the protective film which covers at least part of the electronic components. A height of the protective film is less than or equal to that of the adhesive portion 43. In this embodiment, the adhesive portion 43 is formed by curing adhesive, and the protective film is formed by curing glue. By setting the adhesive portion 43 around the electronic components 42 that need to be covered with the protective film, and arranging the height of the protective film to be less than or equal to that of the adhesive portion 43, the adhesive portion 43 can prevent the glue from overflowing the outside of the circuit board assembly 4 or the designated area when the glue is placed in the area that needs to be coated, which is beneficial to ensuring the thickness of the protective film when the glue is cured into the protective film, and further improving the reliability of the protective film to prevent the electronic components 42 from being corroded by the working medium. Referring to FIG. 3, in this embodiment, the circuit board assembly 4 only includes one adhesive portion 43 which is arranged near the outer periphery of the back surface 412 of the base board 41. The electronic components 42 on the back surface 412 are located in the area surrounded by the adhesive portion 43. The area surrounded by the adhesive portion 43 is provided with the protective film. Such arrangement is beneficial to realizing the mass production of the electronic control board assembly, simplifying the process route of the circuit board assembly, and reducing the production cost of the circuit board assembly, thereby reducing reduce the production cost of the fluid drive device. Also, in other embodiments, it is possible to arrange two or more adhesive portions 43 on the back surface 412 of the circuit board assembly 4. In this case, shapes and sizes of the adhesive portions 43 may be the same or different, and positions of the adhesive portions 43 may be adaptively designed based on the positions of electronic components 42 that need to be covered with the protective film. In addition, in other embodiments, the front surface 411 of the circuit board assembly 4 may also be provided with the corresponding adhesive portion 43.

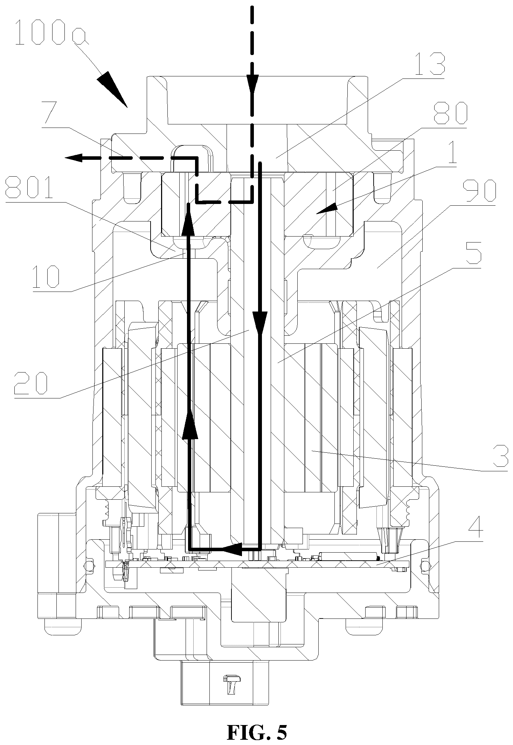

Referring to FIG. 5, FIG. 5 is a schematic structural view of a second embodiment of the fluid drive device according to the present application, and the structure of the second embodiment of the fluid drive device will be described in detail below.

Referring to FIG. 5, the second chamber 90 can accommodate the working medium. When the second chamber 90 accommodates the working medium, at least part of the circuit board assembly 4 is in contact with the working medium located in the second chamber 90. In this way, the working medium in the second chamber 90 can exchange heat with the heat generated by the circuit board assembly 4, which facilitates the heat dissipation of the circuit board assembly 4 and is further beneficial to improving the service life of the fluid drive device 100.

In particular, referring to FIG. 5, in this embodiment, the first chamber 80 is in communication with the second chamber 90. In particular, in this embodiment, the shaft 5 further includes a second passage 20 which is arranged to extend through a first end face and a second end face of the shaft 5. The fluid drive device 100 is provided with an inflow passage 13, and the second passage 20 is communicated with the inflow passage 13. The working medium in the inflow passage 13 can flow into the second chamber 90 and contact with at least part of the circuit board assembly 4 located in the second chamber 90 through the second passage 20, so that the working medium in the second chamber 90 can exchange heat with the heat generated by the circuit board assembly 4, which facilitates the heat dissipation of the circuit board assembly 4 and is further beneficial to improving the service life of the fluid drive device 100. Further, in this embodiment, at least part of the stator assembly 2 may also be in contact with the working medium in the second chamber 90, so that the heat generated by the stator assembly 2 can also exchange heat with the working medium in the second chamber 90, which facilitates the heat dissipation of the stator assembly 2 and is further beneficial to prolonging the service life of the fluid drive device 100. Referring to FIG. 1, the wall surface corresponding to the first chamber 80 includes a bottom wall 802 which supports the first rotor assembly 1. The fluid drive device 100 further includes a first passage 10 which extends through the upper surface and the lower surface of the bottom wall 802, and communicates the first chamber 80 with the second chamber 90. The pressure of the working medium at the inlet of the second passage 20 is greater than the pressure at the outlet of the first passage 10, and the working medium in the second chamber 90 can leave the second chamber 90 through the first passage 10. Since the pressure of the working medium at the inlet of the second passage 20 is greater than the pressure at the outlet of the first passage 10, a pressure difference of the working medium is formed between the inlet of the second passage 20 and the outlet of the first passage 10. According to a principle that the working medium flows from a place with high pressure to a place with low pressure, the working medium in the second chamber 90 can flow towards the outlet of the first passage 10. Since the stator assembly 2 and the circuit board assembly 4 are arranged in the second chamber 90, the flowing working medium can take away at least part of the heat of the stator assembly 2 and the circuit board assembly 4, which is further beneficial to improving the heat dissipation efficiency of the stator assembly 2 and the circuit board assembly 4.

Compared with the first embodiment of the fluid drive device, in this embodiment, the working medium flows into and out of the second chamber 90 through different passages from those in the first embodiment. Other structures of the fluid drive device 100 in this embodiment can refer to the first embodiment of the fluid drive device, and will not be repeated here.

It should be noted that, the above embodiments are only intended to illustrate the present application rather than limit the technical solutions described in the present application. Although the present specification has been described in detail with reference to the embodiments as described above, it should be understood by those skilled in the art that, modifications or equivalent substitutions can still be made by those skilled in the art to the technical solutions of the present application without departing from the spirit and scope of the present application, all of which should be covered within the scope of the claims of the present application.

## Claims

1. A fluid drive device, comprising a first rotor assembly, a second rotor assembly, a stator assembly and a circuit board assembly, wherein the second rotor assembly is connected torque-transmissively to the first rotor assembly, and the stator assembly is electrically connected to the circuit board assembly; the fluid drive device is provided with a first chamber and a second chamber, wherein the first rotor assembly is located in the first chamber, and the stator assembly and the circuit board assembly are located in the second chamber; the first chamber is configured for allowing a working medium to flow therethrough, and the second chamber is configured for accommodating the working medium; and when the second chamber accommodates the working medium, at least part of the circuit board assembly is in contact with the working medium located in the second chamber.

2. The fluid drive device according to claim 1, wherein the first rotor assembly, the stator assembly and the circuit board assembly are arranged in a height direction of the fluid drive device, and at least part of the stator assembly is in contact with the working medium in the second chamber.

3. The fluid drive device according to claim 1 or 2, wherein a wall surface corresponding to the first chamber comprises a bottom wall which supports the first rotor assembly; and the fluid drive device comprises a first passage which extends through an upper surface and a lower surface of the bottom wall and communicates the first chamber with the second chamber.

4. The fluid drive device according to claim 3, wherein at least part of the working medium in the first chamber flows into the second chamber through the first passage; the fluid drive device further comprises a shaft, one end of which is connected with part of the first rotor assembly, and the other end of which is connected with the second rotor assembly; the shaft comprises a second passage which is arranged to extend through a first end face and a second end face of the shaft; and during an operation of the fluid drive device, a pressure of the working medium at an inlet of the first passage is greater than the pressure at an outlet of the second passage, and the working medium leaves the second chamber through the second passage.

5. The fluid drive device according to claim 3, wherein the fluid drive device further comprises a shaft, one end of which is connected with part of the first rotor assembly, and the other end of which is connected with the second rotor assembly; the shaft comprises a second passage which is arranged to extend through a first end face and a second end face of the shaft; the fluid drive device is provided with an inflow passage, the second passage is communicated with the inflow passage, and the second passage is communicated with the second chamber; and during the operation of the fluid drive device, the pressure of the working medium at the inlet of the second passage is greater than the pressure at the outlet of the first passage.

6. The fluid drive device according to claim 1 or 2, wherein the circuit board assembly comprises a base board and electronic components fixedly connected with the base board, and at least part of external surfaces of the electronic components are covered with a protective film.

7. The fluid drive device according to claim 3, wherein the circuit board assembly comprises a base board and electronic components fixedly connected with the base board, and at least part of external surfaces of the electronic components are covered with a protective film.

8. The fluid drive device according to claim 4 or 5, wherein the circuit board assembly comprises a base board and electronic components fixedly connected with the base board, and at least part of external surfaces of the electronic components are covered with a protective film.

9. The fluid drive device according to claim 6, wherein the circuit board assembly further comprises an adhesive portion supported on and adhered to the base board; an outer contour of the adhesive portion is in a closed shape, and at least part of the electronic components covered with the protective film are located in an area surrounded by the adhesive portion; and a height of the protective film is less than or equal to that of the adhesive portion.

10. The fluid drive device according to claim 7, wherein the circuit board assembly further comprises an adhesive portion supported on and adhered to the base board; an outer contour of the adhesive portion is in a closed shape, and at least part of the electronic components covered with the protective film are located in an area surrounded by the adhesive portion; and a height of the protective film is less than or equal to that of the adhesive portion.

11. The fluid drive device according to claim 8, wherein the circuit board assembly further comprises an adhesive portion supported on and adhered to the base board; an outer contour of the adhesive portion is in a closed shape, and at least part of the electronic components covered with the protective film are located in an area surrounded by the adhesive portion; and a height of the protective film is less than or equal to that of the adhesive portion.

12. The fluid drive device according to any one of claims 6 to 11, wherein the fluid drive device further comprises a temperature sensing unit electrically connected with the circuit board assembly and electrically connected with the base board; and the temperature sensing unit is in contact with the working medium in the second chamber to detect a temperature of the working medium in the second chamber.

13. The fluid drive device according to claim 12, wherein the base board comprises a front surface and a back surface, and the front surface is closer to the first rotor assembly than the back surface in the height direction of the fluid drive device; the electronic components comprise heat-generating electronic components, the temperature sensing unit is supported on one of the front surface and the back surface, and the heat-generating electronic components are supported on the other of the front surface and the back surface.

14. The fluid drive device according to any one of claims 1 to 13, wherein the fluid drive device further comprises a motor housing, an upper cover and a bottom cover; at least part of the motor housing is located between the upper cover and the bottom cover in the height direction of the fluid drive device; one side of the motor housing is relatively fixedly connected with the upper cover, and the other side of the motor housing is relatively fixedly connected with the bottom cover; the motor housing is provided with a first accommodating chamber, wherein at least part of the stator assembly is located in the first accommodating chamber, the first accommodating chamber constitutes at least part of the second chamber, and opposing peripheral side walls of the bottom cover and the first accommodating chamber seal against each other.

15. The fluid drive device according to claim 14, wherein the fluid drive device further comprises a first sealing ring; the bottom cover is provided with a groove which is recessed from the outer peripheral surface of the bottom cover; at least part of the first sealing ring is located in the groove; one side of the first sealing ring abuts against the corresponding bottom surface of the groove, and the other side of the first sealing ring abuts against the corresponding peripheral side wall of the first accommodating chamber.
